## Europäisches Patentamt

## European Patent Office

## Office européen des brevets

(11) Publication number: **0 060 641**
A2

# (12) EUROPEAN PATENT APPLICATION

(21) Application number: **82301025.1**

(22) Date of filing: **01.03.82**

(51) Int. Cl.³: **B 41 J 3/20,** H 04 B 9/00, B 41 J 3/16

(30) Priority: **12.03.81 US 242970**

(43) Date of publication of application: **22.09.82**
**Bulletin 82/38**

(84) Designated Contracting States: **AT BE CH DE FR GB LI NL**

(71) Applicant: **NCR CANADA LTD - NCR CANADA LTEE,**
**6865 Century Avenue, Mississauga Ontario,**
**L5N 2E2 (CA)**

(72) Inventor: **Brooks, Raif Maynard, Apt. 304 520 Parkside**
**Drive, Waterloo Ontario N2L 5E3 (CA)**
Inventor: **Miroslav, Sidney Osmera, 46 Roslin Avenue**
**South, Waterloo Ontario N2L 2G8 (CA)**

(74) Representative: **Robinson, Robert George, International**
**Patent Department NCR Limited 206 Marylebone Road,**
**London NW1 6LY (GB)**

(54) **Non-impact dot matrix printer.**

(57) This invention relates to a non-impact dot matrix printer for printing on a record medium (20) movable past a print head (14) by means of light energy carried from a light source means (12) by guide means (16) to the print head (14). The light source means (12) may be a plurality of laser diodes from which the light energy is transmitted to the print head (14) through optic fibers (16).

In operation, a thermal ink bearing ribbon (18) is disposed between the print head (14) and the record medium (20) with which it is maintained in contact and the ink bearing ribbon is locally heated by the transmitted light energy to effect transfer of ink on to the record medium (20).

This printer has the capability of printing magnetic, fluorescent or ordinary ink on any kind of record material, including plain paper.

"NON-IMPACT DOT MATRIX PRINTER"

## Technical Field

This invention relates to a non-impact dot matrix printer.

## Background Art

In the field of non-impact printing, the most common types of printers have been the thermal printer and the ink jet printer. When the performance of a non-impact printer is compared with that of an impact printer, one of the problems in the non-impact machine has been the control of the printing operation. As is well-known, the impact operation depends on the movement of impact members such as wires or the like and which are typically moved by means of an electromechanical system which is believed to enable a more precise control of the impact members.

The advent of non-impact printing, as in the case of thermal printing, brought out the fact that the heating cycle must be controlled in a manner to obtain maximum repeated operations. Likewise, the control of ink jet printing in at least one form thereof must deal with rapid starting and stopping movement of the ink fluid from a supply of the fluid. In each case of non-impact printing, the precise control of the thermal elements and of the ink droplets is necessary to provide for both correct and high-speed printing.

In both thermal and ink jet printing, the print head may be of a multiple-element or nozzle type with the elements or nozzles aligned in a vertical line and supported on a print head carriage which is caused to be moved or driven in a horizontal direction for printing in line manner. Alternatively, the printer structure may include a plurality of equally-spaced, horizontally aligned, single element or nozzle print heads which are caused to be moved in back-and-forth manner to print successive lines of dots in making up the lines of characters.

While ink jet printing and thermal printing have been commonly used in the non-impact field, it is seen that alternatives may include other energy means for effecting printing on record media.

Thus, the U.S. Patent No. 3832488 discloses a non-impact printer which uses light-emitting diodes and flexible optic light guides to generate images to be printed on light-sensitive film. The film is moved continuously in one direction past the image of light and a complete line of characters is printed on the film in linear segments in a light scan mode by selective energization of the diodes.

While the above printer with its imaging lens system is capable of printing on light-sensitive materials, it has no provisions for printing on non-sensitized record material, such as plain paper.

Disclosure of Invention

It is an object of the present invention to provide a non-impact dot matrix printer which uses pulsed light energy to print on any kind of record material, including plain paper.

Thus, according to the invention, there is provided a non-impact dot matrix printer for printing on a record medium movable past a print head, including light source means, and guide means connected with said light source means and said print head for carrying light energy to said print head, characterized by thermal ink bearing means positioned, in operation, between said print head and said record medium and maintained in contact with said record medium, said light energy being effective to produce local heating of said ink bearing means and transfer of ink therefrom on to said record medium.

The preferred embodiment of the invention relates to a non-impact matrix printer which utilizes light energy that is transmitted from a plurality of laser diodes through a fiber optic array to a thermal-sensitive ribbon to form dot matrix characters on paper or like record media maintained in close contact with the ribbon and the print head. The diode laser converts electrical input energy directly into optical output energy and heat is generated to transfer ink from the ribbon onto the paper. The printing or encoding system has the capability of printing magnetic, fluorescent, or ordinary ink on plain paper by using high power laser diodes and carrying the energy through fiber optic directing or coupling cables to the thermal-sensitive ribbon for transferring the ink. In this manner, the heat energy raises the temperature of localized areas of the ribbon to transfer and fuse the ink onto the receiving paper.

The heat energy is directed to the thermal-sensitive ribbon by coupling radiant infra-red light energy from the array of laser diodes through a fiber optic bundle. The configuration of laser diodes and associated optic fibers may be arranged for printing in serial character manner, for printing in serial bar manner, or for printing in dot line manner.

Brief Description of the Drawings

Embodiments of the invention will now be described, by way of example, with reference to the accompanying drawings in which:

Fig. 1 is a block diagram and partial sectional view of a non-impact dot matrix printer in accordance with the present invention;

Fig. 2 is a detailed view of a laser diode and optical fiber coupling;

Fig. 3 is a printing station configuration for printing in serial character manner;

Fig. 4 is a printing station configuration for printing in serial bar manner;

Fig. 5 is a printing station configuration for printing in dot line manner;

Fig. 6 is a block diagram of a preferred print head control and synchronization arrangement; and

Fig. 7 is a preferred circuit arrangement for driving the laser diode.

Best Mode of Carrying out the Invention

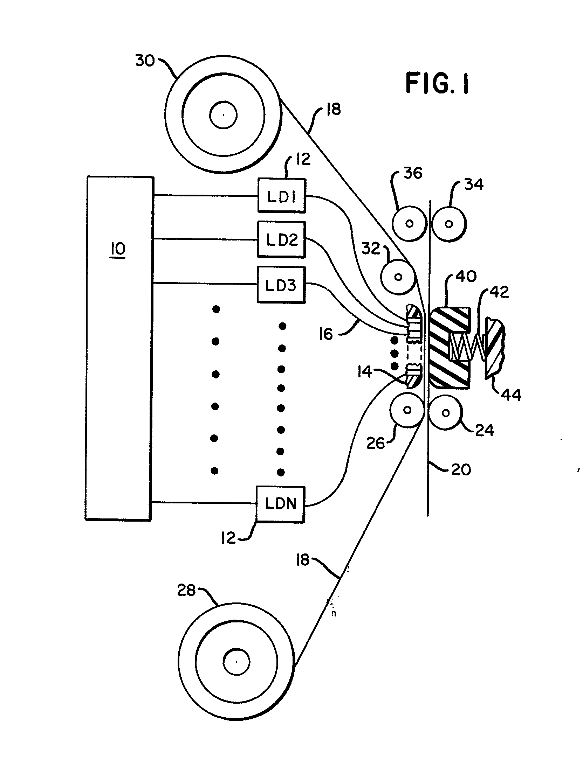

Referring now to the drawing, Fig. 1 shows in diagrammatic form, a printer incorporating print head control and synchronization circuitry 10 for a plurality of energy-emitting elements in the form of laser diodes 12 which direct radiation to a print head 14 through a plurality of fiber optic passageways or conduits 16.

The print head 14 is supported in a position adjacent a printing station wherein an ink-carrying member in the form of a thermal-sensitive ribbon 18 and record media in the form of paper 20 are caused to be advanced or moved past the station by well-known means. Suitable transport or drive rollers 24 and 26 move the ribbon 18 and the paper 20 past the station with the ribbon unwinding from a supply reel 28 and winding on a take-up reel 30. The ribbon is maintained in a path beyond the printing station by a guide roller 32 and the paper or other document 20 is maintained in a plane by rollers 34 and 36.

A pressure platen 40 is urged by a spring 42 from a fixed member 44 in a direction toward the printing station so as to maintain close contact between the print head 14, the ribbon 18 and the paper 20. The ribbon 18 is in continuous contact with the face of the print head 14 and the paper 20 is in continuous contact with the platen 40 as the ribbon and paper are caused to be driven past the printing station. In this manner, the ribbon 18 and the paper 20 are moved together in their travel past the station, the effect being that there is no relative movement between these elements during operation.

The pressure platen 40 enables the maintaining of close physical contact between the donor ribbon 18 and the receiving paper 20. When the thermal-sensitive ribbon 18 is heated by the directed laser diode beam, the primary heat sensitive compound in the ribbon begins to melt within the diameter of the beam of energy, and it is possible to capture on the receiving paper the melted pool of ink granules by reason of the close contact between the ribbon 18 and the paper 20.

The laser diode 12, which may also be called a diode laser, is defined as a pn junction semiconductor electron device which converts direct forward bias electrical input directly into coherent optical output by means of a process of stimulated emission in the region near the junction. The heat energy is directed by coupling the radiant infrared light energy from the laser diodes 12 through the fiber optic bundle to the thermal sensitive ink ribbon 18. The infrared energy pertains to or designates those radiations with wavelengths just beyond the red end of the visible spectrum which wavelengths are longer than those of visible light and shorter than those of radio waves.

The laser diodes used in the present invention are noted as being high power diodes with emissions in the near infrared range and are commercially available in the LD series or the LA series with output power as high as 1,000 watts at 940 nanometers and 840 nanometers, respectively, as manufactured by Laser Diode Laboratories of Metuchen, New Jersey.

The print head 14 includes a face plate or like member for positioning one end of a single optic fiber or a plurality of optic fibers or conduits 16 in a vertical column arrangement.

When it is desired to print a dot with laser diode 12 designated LD1, the print head control and synchronization electronics selects the laser diode LD1 and effects a short intense burst of infrared radiation. The radiated light energy is coupled through the fiber optic 16 directly connected with LD1 and is carried to the face of the plate which positions the ends of the optic fibers in close proximity with the ribbon 18. The output radiant energy from the LD1 fiber optic strand is absorbed in the thermal-sensitive ribbon 18 and thereby causes ink to be transferred to and fused in the paper 20.

The method and mechanism for transfer of ink is based on the thermo-elasto-plastic relationship whereupon illumination by the intense infrared pulse effects an expansion of the area encompassed by the LD1 fiber optic light beam as a result of thermo-elastic stress waves having a positive surface curvature. When the energy and the temperature is raised to a point where the primary heat-sensitive compound in the ribbon 18 begins to melt, a pool of ink situated within the light beam diameter is caused to be transferred onto the receiving media or paper 20.

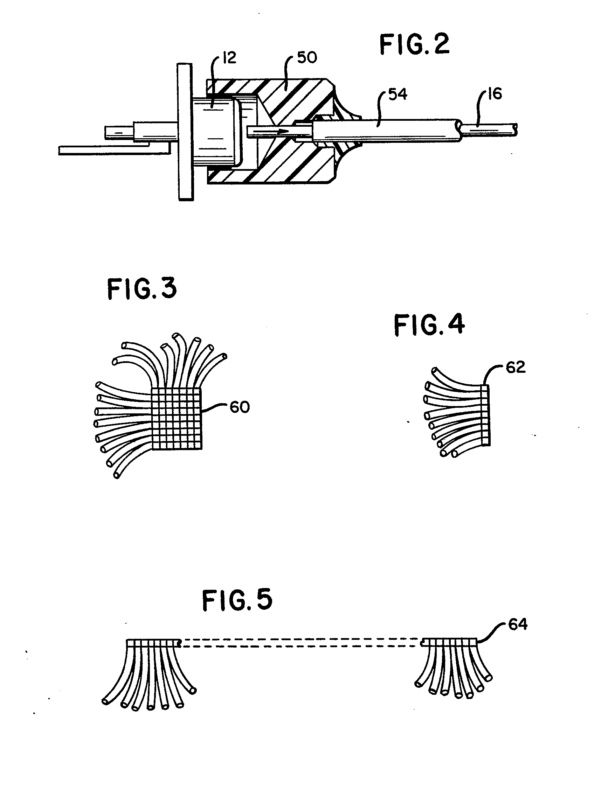

Fig. 2 illustrates the details of a laser diode 12 and the connection with an optical fiber 16 which includes an alignment cap 50 which is fitted in sealing manner with the diode and with a protective tubing 54 over the fiber.

Figs. 3, 4 and 5 show different configurations for serial character, bar code and dot line printing respectively. Fig. 3 is a front view of a printing plate in the form of a 7 X 9 matrix 60 for printing characters in serial manner wherein the character is formed by selection of the laser diodes 12 activated in the desired mode by the print head control and synchronization circuitry 10. The heat energy is carried by a plurality of the optic fibers 16 arranged in both x and y directions. The resolution of the character matrix can be enhanced by decreasing the fiber optic diameter while increasing the number of fiber optic strands and the associated laser diodes.

Fig. 4 illustrates the front face or surface of a printing plate associated with a serial bar printer wherein all of the laser diodes are activated simultaneously for printing successive bars 62 or bar codes. The width of each bar is controlled by the length of time of the activation of the laser diodes for carrying the energy through the fibers 16.

Fig. 5 shows the arrangement of the fiber optic front plate for printing a line 64 of dots at a time by means of the energy carried through the fibers 16. The characters in a given line are composed row by row as the receiving document and ribbon move upwardly past the print station.

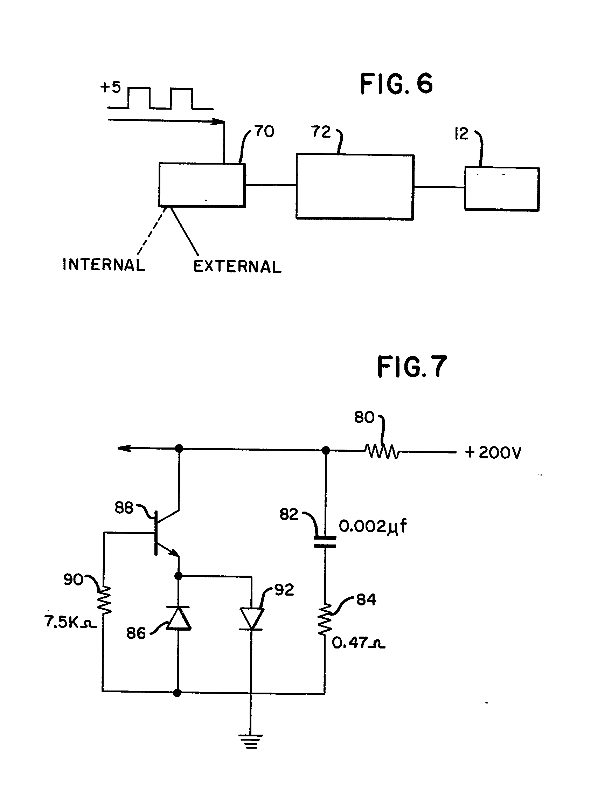

The print head control and synchronization circuitry 10 includes, as seen in Fig. 6, a power supply 70 (Laser Diode Lab. Model LC-200) mated with a pulse generator 72 (Laser Diode Lab. Model LP-210) for controlling a given laser diode 12. When the switch on the power supply 70 is in the EXTERNAL position, a TTL pulse at the desired repetition rate connected to the EXTERNAL TRIGGER input will trigger the given laser diode 12. When the switch on the power supply 70 is in the INTERNAL position, the laser diode 12 is triggered at a predetermined steady rate.

An alternative arrangement is to use Laser Diode Lab. Model LP-11 or LP-200 pulse generator connected to a DC power supply. In this manner the generator has a variable internal repetition rate control which allows selection of the rate at which the system triggers the laser diode or array thereof.

Fig. 7 shows a simple circuit for a fixed repetition rate, wherein a 200 volt pulse is directed through a resistor 80. A capacitor 82 and a resistor 84 are series connected in R-C manner with a diode 86, in turn, connected with the emitter of a transistor 88, there being a resistor 90 connected to the plate. The collector of the transistor 88 is connected with the output of resistor 80 which is connected to drive the laser diode in a self-oscillating manner. An indicator light emitting diode 92 is connected between the emitter of transistor 88 and ground potential to indicate circuit oscillation.

Claims

1.    A non-impact dot matrix printer for printing on a record medium (20) movable past a print head (14), including light source means (12), and guide means (16) connected with said light source means (12) and said print head 14) for carrying light energy to said print head (14), characterized by thermal ink bearing means (18) positioned, in operation, between said print head (14) and said record medium (20) and maintained in contact with said record medium (20), said light energy being effective to produce local heating of said ink bearing means (18) and transfer of ink therefrom on to said record medium (20).

2.    A printer according to Claim 1, characterized by platen means (40) arranged opposite to said print head (14) and biased to maintain, in operation, said record medium (20) in contact with said ink bearing means (18), and to maintain said ink bearing means (18) in contact with said print head (14).

3.    A printer according to either Claim 1 or 2, characterized in that said thermal ink bearing means (18) is a heat sensitive ribbon.

4.    A printer according to either Claim 1 or 2, characterized in that said record medium (20) is a sheet of plain paper.

5.    A printer according to either Claim 1 or 2, characterized in that said light source means (12) includes at least one laser diode (LD1).

6.    A printer according to either Claim 1 or 2, characterized in that said guide means (16) includes at least one optical fiber

7.    A printer according to either Claim 1 or 2, characterized in that said guide means (16) includes a plurality of optical fiber each having one end thereof connected with a corresponding aperture in said print head (14), and the other end with a laser diode, so as to carry light energy from each laser diode to the corresponding aperture, when said laser diode is pulsed.

8.    A printer according to Claim 7, characterized in that said print head (14) is movable parallel to the line of printing and has a two dimensional array of apertures therein to form a character matrix (60) for serially printing a row of characters.

0060641

9.     A printer according to Claim 7, characterized in that said print head is movable parallel to the line of printing and has apertures therein arranged in a line extending perpendicularly to said line of printing for serially printing successive bars (62) or bar codes.

10.    A printer according to Claim 7, characterized in that said print head extends along the width of the line of printing and has apertures therein arranged in a line corresponding to said line of printing (64) for printing a matrix of characters row by row.

FIG. 1

FIG. 2

FIG. 3

FIG. 4

FIG. 5

0060641

## FIG. 6

+5

INTERNAL  EXTERNAL

70   72   12

## FIG. 7

80

+200V

88

82   0.002μf

90

7.5KΩ   86   92   84

0.47Ω